# EUROPEAN PATENT SPECIFICATION

(11) **EP 3 519 161 B1**
(45) Date of publication and mention of the grant of the patent: **16.12.2020**
(21) Application number: 17771783.2
(22) Date of filing: 28.09.2017
(51) Int. Cl.: B81C 1/00, C23C 16/01, C23C 16/04, C23C 16/455, C23G 1/12, C23G 1/22, C25D 11/04, C25D 11/12, C25D 11/18, H01L 31/0216, B29C 65/00, H01J 9/02, H01M 4/86, H01M 4/88, B82Y 30/00

(54) **PROCESS FOR THE PRODUCTION OF AN ORGANIZED NETWORK OF NANOWIRES ON A METALLIC SUBSTRATE**
VERFAHREN ZUR HERSTELLUNG EINES ORGANISIERTEN NETZWERKS VON NANODRÄHTEN AUF EINEM METALLISCHEN SUBSTRAT.
PROCEDE POUR LA PREPARATION D'UN RESEAU ORGANISE DE NANOFILS SUR UN SUBSTRAT METALLIQUE.

(30) Priority: 30.09.2016 LU 93245
(43) Date of publication of application: 07.08.2019
(73) Proprietor: Luxembourg Institute of Science and Technology (LIST), 4362 Esch-sur-Alzette (LU)
(72) Inventor: ISHCHENKO, Olga, 91140 Villebon sur Yvette (FR); LENOBLE, Damien, 6920 Wellin (BE)
(74) Representative: Lecomte & Partners
(86) International application number: PCT/EP2017/074605
(87) International publication number: WO 2018/060320

(56) References cited:
- WO-A1-2014/131432
- WO-A2-2010/124258
- KR-A- 20100 075 032
- US-A1- 2002 167 256
- LIU SUQIN ET AL: "Straightforward fabrication of highly ordered TiO"2 nanowire arrays in AAM on aluminum substrate", SOLAR ENERGY MATERIALS AND SOLAR CELLS, ELSEVIER SCIENCE PUBLISHERS, AMSTERDAM, NL, vol. 85, no. 1, 1 January 2005 (2005-01-01), pages 125-131, XP027815019, ISSN: 0927-0248 [retrieved on 2005-01-01]

## Description

### Technical field

The invention concerns a process for the production of an organized network of nanowires on a metallic substrate.

### Background art

The light management approaches attract considerable attention in photovoltaics. This strategy mainly targets two goals: antireflection (AR) and absorption enhancement. Given that, the increase of light absorption would be also relevant for the photocatalysis.

Fundamental studies on the antireflection principles were already well investigated on bulk materials. The maximum of achievable absorption on solar cells was determined to be 4n², known as Yablonovitch or Lambertian limit (where n is refractive index of the semiconductor material). This limit was determined by Yablonovitch and Cody based on Lambertian scatter (see Yablonovitch E. et al., IEEE Trans. Electron Devices, 1982, 29(2), 300-305). Various studies intend to reach this limit and photonic structures have been considered to go beyond this theoretical limit. It was shown that the use of periodic structures could increase the density of optical modes (see Brongersma M. L. et al., Nat. Mater., 2014, 13(5), 451-460). Therefore, the key parameters determining the interaction light/material are spacing, spatial arrangement and optical properties of materials. Some publications even underlined the importance of geometry that may prevail intrinsic material properties (see Leung S. F. *and al.,* **2014**, *5(8)*, 1479-1495). This phenomenon is based on the light scattering and reflection on periodic nanostructures which increases the optical path. The sharp nanostructures such as nanocones, nanoneedles with dimensions below the light wavelength act as an anti-reflective coating (ARC), whereas the nanostructures with uniform diameters such as nanowires show fundamental photonic resonant modes and could lead to the light confinement and absorption.

In order to manufacture those organized network of nanowires on metallic substrate, different approaches may be taken into consideration, notably the template-assisted approach.

The template-assisted approach consists of the following steps: (i) the fabrication of well-ordered porous substrates (for instance, anodized aluminium oxide, AAO); (ii) deposition of conformal metal-oxide thin films by ALD on porous surfaces; (iii) the removal of AAO template using wet-etching process in basic or acid solution.

Such fabrication procedure is already well known and widely reported in the literature. See for instance the works of YaO Z. et al., Nanoscale Res. Lett., 2015, 10 (1), 166, of Liu S. et al., Straightforward fabrication of highly ordered TiO2 nanowire arrays in AAM on aluminium substrate, 2005, 85, 125-131 and of Shi L. et al., Nanoscale, 2010, 2, 2104-2108.

However, an important drawback of this approach is the poor control of nanostructures organisation, which tends to aggregate due to their high aspect ratio. To avoid this problem, anodization the Al-film deposited directly on the surface could be done. Chang Y.-H. et al., in ACS Appl. Mater. Interfaces, 2013, 5 (9), 3549-3545, realised AAO directly on Si and quartz substrates for the fabrication of TiO₂ nanotubes. However, the authors did not mention how to remove the alumina matrix and did not report on the final organisation of the nanotubes. YaO Z. *et al.* researched TiO₂ deposition into 500-nm-thick AAO with approximately 170 nm of over-deposition on top of the membrane. The authors demonstrated the well-organised nanowires, which tended to aggregate. Moreover, the authors did not report on the nanowires functionalities. A sticking with the sample-holder is required in order to manipulate the nanowires network.

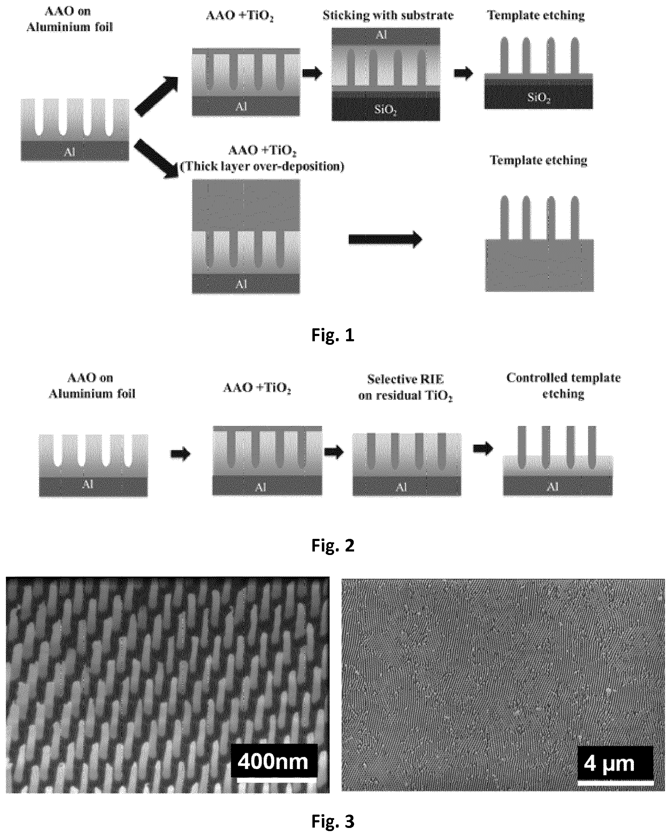

The fabrication steps generally presented in the literature (see figure 1) face the manipulation difficulties described above. Sticking layer which must provide excellent thermal and chemical stability was not found.

### Summary of invention

### Technical Problem

The goal of the invention is to improve the quality of the functionalized substrate, in relation with the aggregation phenomenon and in relation with the monitoring of the density and spacing of the nanowire into the deposited network.

### Technical solution

The invention is directed to a process for producing of an organized network of nanowires on metallic substrate, said process comprising the steps of (a) providing a metallic substrate; (b) anodizing said metallic substrate so as to form an oxide layer on said metallic substrate; (c) etching the oxide layer which has been formed in step (b) so as to form a template; (d) depositing a component in the template formed in step (c), said component forming said nanowires; (e) etching the residual amount of component; and (f) etching partially the oxide layer so as to remove partially said template. Said nanowires are embedded in said oxide layer.

According to a preferred embodiment, said step (c) is performed as far as said metallic substrate is partially uncovered from said oxide layer and wherein said step (d) is a step of depositing said component in the template and on said uncovered part of said metallic substrate.

According to a preferred embodiment, said step (c) is the step of etching between 1% and 100% of the thickness of the oxide layer which has been formed in step (b), preferentially the step of etching between 5% and 80% of said thickness, more preferentially the step of etching between 10% and 50% of said thickness, even more preferentially the step of etching between 20% and 30% of said thickness.

According to a preferred embodiment, said metallic substrate is an aluminium substrate, preferentially an aluminium foil, and wherein said oxide layer is aluminium oxide.

According to a preferred embodiment, said nanowire is a superconducting nanowire, a metallic nanowire, a semiconducting nanowire, an insulating nanowire or a nanowire based on an heterostructure.

According to a preferred embodiment, said nanowire is a nanowire based on titanium oxide.

According to a preferred embodiment, said oxide layer is doped.

According to a preferred embodiment, said step (b) comprises a first anodising step so as to form a porous oxide layer film onto said metallic substrate and a second anodising step so as to form an organised porous oxide layer film onto said metallic substrate.

According to a preferred embodiment, said step (d) is performed by atomic layer deposition.

According to a preferred embodiment, said deposition is performed at a temperature comprised between 100°C and 200°C.

According to a preferred embodiment, said step (e) is performed by dry-etching.

According to a preferred embodiment, said step (e) is performed by anisotropic etching, preferentially by reactive ion etching.

According to a preferred embodiment, said step (f) is performed by wet-etching.

According to a preferred embodiment, said process further comprises an additional step of annealing between said steps (c) and (d).

According to a preferred embodiment, said process further comprises an additional step of treatment with oxygen plasma after said step (f).

According to a preferred embodiment, said process further comprises an additional step of annealing after said step (f) or after said additional step of treatment with oxygen plasma after said step (f).

### Advantages of the invention

The invention is particularly interesting in that the process of the present invention allows the control of different parameters during the production of functionalized metallic substrate. The aggregation of the nanowires, their density and spacing are controlled. The height of the formed nanowires is also manageable. Such process can further be applied in large-scale. It also brings the benefit of having highly reflective aluminium under-layer.

### Brief description of the drawings

Figure 1: Illustration of known processes of manufacturing a network of nanowires on an aluminium substrate.
Figure 2: Illustration of the process in accordance with the present invention.
Figure 3: Optical images of periodic free standing TiO₂ nanowires (S70).
Figure 4: Reaction ion etching rate for TiO₂ (a) and SnO₂ (b) films.
Figure 5: Optical images on TiO₂ and TiO₂/SnO₂ after applied RIE.
Figure 6: AAO matrix defects.
Figure 7: Non-homogeneous etching alumina matrix.
Figure 8: Propagating of matrix defects leading to over-etching.
Figure 9: EDX spectra on TiO₂ nanowires (S70) before and after O₂ plasma treatment.
Figure 10: XRD diffractograms on TiO₂ nanowires after annealing at 600°C.
Figure 11: Scheme of a cross-section of the network of the nanowire on the aluminium substrate.
Figure 12: Tailoring of TiO₂ nanowires diameter and spacing (S500).

### Description of an embodiment

To overcome this issue, a new fabrication protocol was developed. After the deposition of metal-oxide into the porous template, dry-etching was performed to remove the residual oxide layer and then wet-etching was applied for the controllable removal of alumina. Figure 2 illustrates the process according to the present invention.

The development of AAO membranes with specific parameters is required for the tuning of the nanowires aspect ratio. The fabrication of AAO is a well-known process, which consists in two anodizing steps. The Al foil is initially electrochemically polished in a solution of perchloric acid and absolute ethanol (25 mL/100 mL). In order to avoid over-heating, the electrochemical cell is chilled at -4°C. The solution temperature is additionally controlled by an external thermometer. Therefore, the electropolishing is performed by applying a voltage of 35 V and a current of 4 A. When the electrolyte temperature reached 12°C, the anodizing process is turned off until the decrease of the solution temperature to -1°C. The sequence of the electro- polishing and cooling steps is performed to achieve a mirror Al surface and to avoid the over-heating of the perchloric acid solution.

The anodizing process is performed in oxalic acid (0.3 mol) at 1°C in two steps. In the first anodizing step, applying a voltage of 50 V during 2 h leads to the formation of porous alumina film. This film needs to be removed in order to obtain a void-like Al surface. Typically, the mixture of chromic and phosphoric acids (80 ml H₂O, 1.47 g CrO₃ and 2.76 ml H₃PO₄) heated at 80°C for 30 min is used for the selective alumina etching. The second anodizing step is performed in similar conditions as the first one, on pre-structured Al surface, and forms the well-organized porous materials. Consequently, the pore depth is triggered by the anodizing time. In our case, to achieve a pore depth of 1-2 µm, the duration of the second anodizing step is 15-30 min.

Following the fabrication approach presented on figure 2, the deposition of the metal-oxide thin films into porous AAO membranes is performed by atomic layer deposition (ALD). A conformal ALD on porous surface inevitably forms a residual film on top of the membrane, and thus needs to be removed, for example by etching.

The deposition at room temperature is very homogenous into pores, however the use of amorphous film leads to the systematic over-etching and the loss of nanowires during the H₃PO₄ wet-etching.

Depositions performed at 100 and 200°C forms also smooth and dense TiO₂ films which enabled the development of TiO₂ nanowires as seen on figure 3. The nanowire dimensions are measured by SEM - tilted images with the angular correction, showing nanowires diameter around of 40 nm, length of 350 nm and spacing of -70-80 nm (S70).

Reactive Ion Etching (RIE) is a powerful tool for the large scale nanostructuration. Plasma etching has significant advantages for the pattern transfer of nanoscale features compared to wet-etching. RIE ensures an anisotropic etching; moreover it is a relatively clean process and does not produce chemical waste. Typically, various types of masks, almost insensitive to the etching agent, are used for the features fabrication. The RIE mechanism depends on the etching agent (reactive gas) and its interaction with the treated material. Gases such as nitrogen or argon are often used for sputtering, rather than a selective etching.

In the literature, the typical metal-oxide etching process is performed using halide gases such as Cl₂ or Br₂, which demonstrate a high etching efficiency (see Krishnamoorthy S. et al., Adv. Funct. Mater., 2011, 21 (6), 1102-1112). The fluorine-based gases, such as CF₄, C₄F₈, CHF₃, SF₆ etc., are appropriate for the SiO₂ etching, and they present lower ability for the metal-oxides (type TiO₂, SnO₂) etching, and are used to require a high density plasma.

The Plasma-Therm 790 Reactive Ion Etcher is used to remove the TiO₂ and SnO₂ residual layers on the top of AAO after ALD deposition. RIE Plasma-Therm 790 is appropriate for various RIE processing on silicon wafers up to 200 mm diameter. Four gas sources are available for the etching processes: oxygen, nitrogen, argon and CF₄.

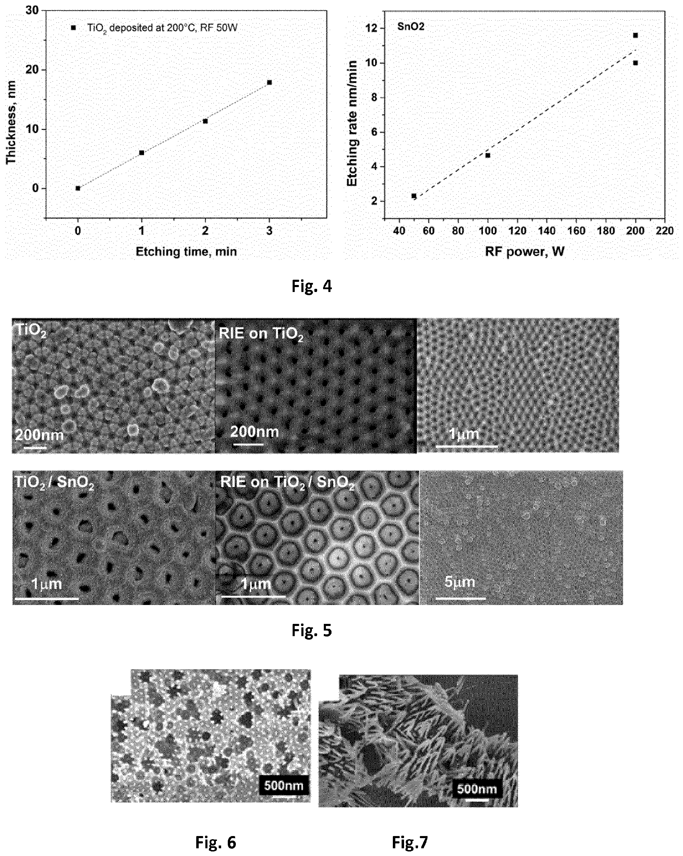

The RIE of TiO₂ and SnO₂ are optimized using a reactive gas mixture of CF₄, Ar and O₂, in proportion 32:8:6 seem. The TiO₂ deposited at low temperature is amorphous and its etching is achieved with 50 W, 60 mTorr. In these conditions, the etching rate is determined at 5nm/min. The SnO₂ film, which is already crystalline after the deposition, requires a more powerful plasma to achieve a similar etching rate (see figure 4). Therefore, SnO₂ etching conditions are optimal at 200 W and 60 mTorr.

Figure 5 shows scanning electron microscope (SEM) pictures of samples after RIE treatment. They indicate a very homogeneous etching of the residual metal-oxide films that were deposited on top of the membrane. The removal of this residual film allows to access to the alumina matrix for the further wet-etching step.

Following the step of dry-etching the residual amount of the deposited component, a step of wet-etching is undertaken in order to remove partially the template.

The wet-etching setup is performed by fixing samples in the sample holder and placed them in a beaker with an etching agent. The sample holder maintains the sample parallel to the stirring rotation and keeps the distance between the sample surface and the magnetic stirring ∼2 cm.

The accurate wet etching of the alumina matrix is still a technology challenge to achieve. In the literature, the wet-etching step is generally not well-assessed as it consists of a complete alumina removal (over-etching), as it is presented on figure 1. Therefore, the goal of the wet-etching development is to achieve an accurate etching of alumina on the partially removed matrix and to preserve the rest of the matrix to hold the periodic structures that prevents their aggregation.

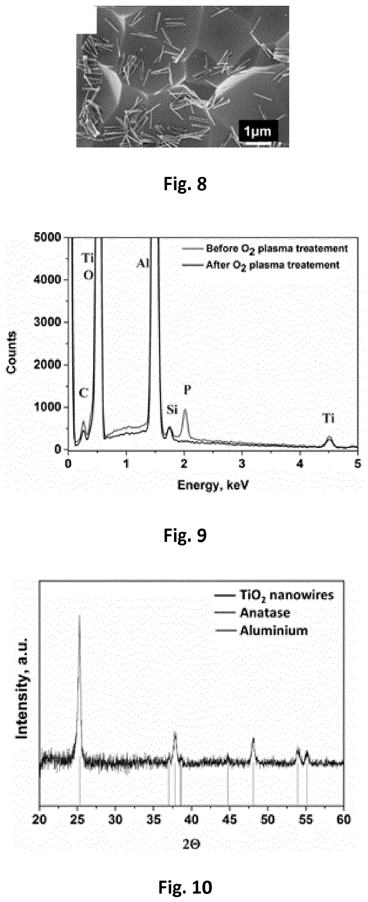

The alumina is known to be soluble in acid and basic medium. The first etching tests are realized using aqueous solution of NaOH (4wt%). The SEM pictures of the samples after 5-20 min of etching at room temperature show a highly aggressive etching with the creation of numerous defects in the matrix. Another etching agent being also often used in the literature is the phosphoric acid (H₃PO₄). The use of various H₃PO₄ concentrations (1 to 5 M) demonstrates a significant improvement on the etching control. Moreover, the etching rate in the case of H₃PO₄ at ambient conditions is very slow. The main problems that are faced during the wet-etching optimization are the non-homogeneity of the porous alumina (see figure 6), the presence of some areas where the etching rate is more important, and local mechanical defects as cracks leading to multidirectional etching. Local isotropic etching is extremely undesirable in the case of long-time wet-etching processes. The non-uniform etching creates local defects (see figure 7) that propagate to the rest of the matrix leading to either the creation of a large number of defects, or premature over-etching (see figure 8).

The annealing of porous substrates prior to the ALD deposition improves the matrix quality and significantly reduces the number of local non-homogeneities. However, the presence of small mechanical defects, such as cracks is still difficult to prevent. To solve this issue, we propose to apply concentrated H₃PO₄ (85%) mainly because of its high viscosity. The surface tension improves the etching homogeneity, even in the presence of local cracks. The viscous solution could not easily penetrate into a crack, which ensures unidirectional etching. Finally, the optimization of the wet-etching of AAO allows to get a good control during this fabrication step. The nanostructures are developed by applying 15-20 h of H₃PO₄ etching. The alumina etching rate is determined at -20 nm/h for membranes with pores diameter of 40 nm and 40 nm/h for membranes with pores of 180 nm.

Figure 9 shows Energy-Dispersive X-ray (EDX) spectroscopy analyses which have been realized on nanostructures after the wet-etching and reveals an important phosphorus contamination. The oxygen plasma at high power is able to remove the phosphorous surface contamination.

The EDX spectra realized on the nanowires after the H₃PO₄ etching show an important surface contamination by phosphor. Oxygen plasma treatment has been used to get rid of this contamination.

Additional annealing step at 600°C for 2 h in ambient air may be used to improve the crystalline quality of samples, as shown by the X-Ray Diffraction (XRD) analyses illustrated on figure 10.

According to the SEM characterizations, arrays of periodic metal-oxide nanowires (TiO₂) with length of 350-450 nm, diameter of 40 nm and heterostructures (TiO₂/SnO₂) with length of 600 nm and diameter of 180 nm demonstrated a low number of matrix defects, and a high uniformity at large scale.

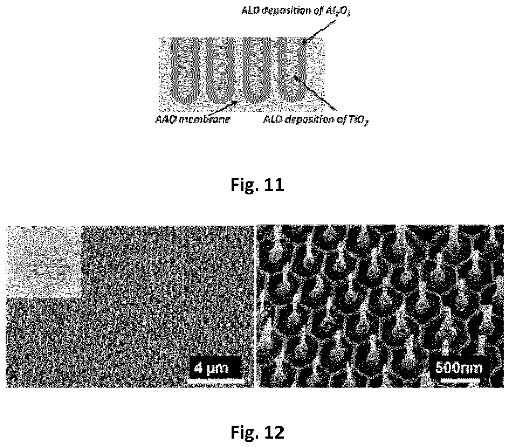

The diameters and spacing of the nanowires are determined by the pores diameter and their spacing in the AAO membrane. It is possible to tune the pore diameter and spacing by initially using AAO membranes with large pore sizes (200 nm), and adjusting the required pore diameters by subsequent ALD deposition of alumina. Following the already established nanowires fabrication protocol, TiO₂ nanowires that have 40 nm diameter, 500 nm spacing and 600 nm length are thus developed (S500). The wet-etching rate of the anodized alumina is found slightly faster than the alumina deposited by ALD, which justified the formation of the "nano-flasks" with the bottom widening due to the less-etched ALD deposited alumina (see figures 11 and 12).

## Claims

1. Process for production of an organized network of nanowires on metallic substrate, said process comprising the following steps:
a) providing a metallic substrate;
b) anodizing said metallic substrate so as to form an oxide layer on said metallic substrate;
c) etching the oxide layer which has been formed in step (b) so as to form a template;
d) depositing a component in the template formed in step (c), said component forming said nanowires;
e) etching the residual amount of component; and
f) etching partially the oxide layer so as to remove partially said template;
wherein said nanowires are embedded in said oxide layer.

2. Process according to claim 1, wherein said step (c) is performed as far as said metallic substrate is partially uncovered from said oxide layer and wherein said step (d) is a step of depositing said component in the template and on said uncovered part of said metallic substrate.

3. Process according to any one of claims 1-2, wherein said metallic substrate is an aluminium substrate, preferentially an aluminium foil, and wherein said oxide layer is aluminium oxide.

4. Process according to any one of claims 1-3, wherein said nanowire is a superconducting nanowire, a metallic nanowire, a semiconducting nanowire, an insulating nanowire or a nanowire based on an heterostructure.

5. Process according to any one of claims 1-3, wherein said nanowire is a nanowire based on titanium oxide.

6. Process according to any one of claims 1-5, wherein said oxide layer is doped.

7. Process according to any one of claims 1-6, wherein said step (b) comprises a first anodising step so as to form a porous oxide layer film onto said metallic substrate and a second anodising step so as to form an organised porous oxide layer film onto said metallic substrate.

8. Process according to any one of claims 1-7, wherein said step (d) is performed by atomic layer deposition.

9. Process according to claim 8, wherein said deposition is performed at a temperature comprised between 100°C and 200°C.

10. Process according to any one of claims 1-9, wherein said step (e) is performed by dry-etching.

11. Process according to any one of claims 1-9, wherein said step (e) is performed by anisotropic etching, preferentially by reactive ion etching.

12. Process according to any one of claims 1-11, wherein said step (f) is performed by wet-etching.

13. Process according to any one of claims 1-12, wherein said process further comprises an additional step of annealing between said steps (c) and (d).

14. Process according to any one of claims 1-13, wherein said process further comprises an additional step of treatment with oxygen plasma after said step (f).

15. Process according to any one of claims 1-14, wherein said process further comprises an additional step of annealing after said step (f) or after said additional step defined in claim 14.

## Patentansprüche

1. Verfahren zur Herstellung eines organisierten Netzes von Nanodrähten auf einem metallischen Substrat, wobei das Verfahren die folgenden Schritte umfasst:
a) Bereitstellen eines metallischen Substrats;
b) Anodisieren des metallischen Substrats, um eine Oxidschicht auf dem metallischen Substrat auszubilden;
c) Ätzen der Oxidschicht, die in Schritt (b) ausgebildet wurde, um ein Template zu bilden;
d) Abscheiden einer Komponente in dem Template, das in Schritt (c) ausgebildet wurde, wobei die Komponente die Nanodrähte bildet;
e) Ätzen der verbliebenen Komponente; und
f) partiell Ätzen der Oxidschicht, um das Template partiell zu entfernen;
wobei die Nanodrähte in die Oxidschicht eingebettet sind.

2. Verfahren nach Anspruch 1, wobei Schritt (c) so weit durchgeführt wird, wie das metallische Substrat unter der Oxidschicht freigelegt wurde, und wobei der Schritt (d) ein Schritt des Abscheidens der Komponente in dem Template und auf dem freigelegten Teil des metallischen Substrats ist.

3. Verfahren nach einem der Ansprüche 1-2, wobei das metallische Substrat ein Aluminiumsubstrat ist, vorzugsweise eine Aluminiumfolie, und wobei die Oxidschicht Aluminiumoxid ist.

4. Verfahren nach einem der Ansprüche 1-3, wobei der Nanodraht ein superleitender Nanodraht, ein metallischer Nanodraht, ein Halbleiter-Nanodraht, ein isolierender Nanodraht oder ein auf einer Heterostruktur basierender Nanodraht ist.

5. Verfahren nach einem der Ansprüche 1-3, wobei der Nandodraht ein auf Titanoxid basierender Nanodraht ist.

6. Verfahren nach einem der Ansprüche 1-5, wobei die Oxidschicht dotiert ist.

7. Verfahren nach einem der Ansprüche 1-6, wobei der Schritt (b) umfasst: einen ersten Anodisierungsschritt, um einen Überzug aus einer porösen Oxidschicht auf dem metallischen Substrat zu bilden, und einen Anodisierungsschritt, um einen Überzug aus einer organisierten porösen Oxidschicht auf dem metallischen Substrat zu bilden.

8. Verfahren nach einem der Ansprüche 1-7, wobei der Schritt (d) durch Atomschichtabscheidung gebildet wird.

9. Verfahren nach Anspruch 8, wobei die Abscheidung bei einer Temperatur durchgeführt wird, die zwischen 100 °C und 200 °C liegt.

10. Verfahren nach einem der Ansprüche 1-9, wobei der Schritt (e) durch Trockenätzen durchgeführt wird.

11. Verfahren nach einem der Ansprüche 1-9, wobei der Schritt (e) durch anisotropes Ätzen, vorzugsweise durch reaktives lonenätzen durchgeführt wird.

12. Verfahren nach einem der Ansprüche 1-11, wobei der Schritt (f) durch Nassätzen durchgeführt wird.

13. Verfahren nach einem der Ansprüche 1-12, wobei das Verfahren ferner zwischen den Schritten (c) und (d) einen zusätzlichen Temperungsschritt umfasst.

14. Verfahren nach einem der Ansprüche 1-13, wobei das Verfahren nach Schritt (f) ferner einen zusätzlichen Schritt der Behandlung mit Sauerstoffplasma umfasst.

15. Verfahren nach einem der Ansprüche 1-14, wobei der Prozess ferner nach Schritt (f) oder nach dem zusätzlichen Schritt, der in Anspruch 14 definiert ist, einen zusätzlichen Temperungsschritt umfasst.

## Revendications

1. Procédé destiné à la production d'un réseau organisé de nanofils sur un substrat métallique, le procédé en question comprenant les étapes suivantes dans lesquelles :
a) on procure un substrat métallique ;
b) on soumet ledit substrat métallique à une anodisation de manière à former une couche d'oxyde sur ledit substrat métallique ;
c) on soumet à une gravure la couche d'oxyde qui a été formée à l'étape (b) de façon à obtenir une matrice ;
d) on dépose un composant dans la matrice qui a été formée à l'étape (c), ledit composant formant lesdits nanofils ;
e) on soumet la quantité résiduelle du composant à une gravure ; et
f) on soumet la couche d'oxyde à une gravure partielle de façon à éliminer en partie ladite matrice ;
dans lequel lesdits nanofils sont incorporés dans ladite couche d'oxyde.

2. Procédé selon la revendication 1, dans lequel ladite étape (c) est mise en œuvre d'une manière telle que ledit substrat métallique est en partie mis à nu par rapport à ladite couche d'oxyde ; et dans lequel ladite étape (d) représente une étape qui consiste à déposer ledit composant dans la matrice et sur ladite partie mise à nu dudit substrat métallique.

3. Procédé selon l'une quelconque des revendications 1 à 2, dans lequel ledit substrat métallique est un substrat en aluminium, de préférence une feuille mince en aluminium ; et dans lequel ladite couche d'oxyde est de l'oxyde d'aluminium.

4. Procédé selon l'une quelconque des revendications 1 à 3, dans lequel ledit nanofil est un nanofil supraconducteur, un nanofil métallique, un nanofil semi-conducteur, un nanofil isolant ou un nanofil basé sur une hétérostructure.

5. Procédé selon l'une quelconque des revendications 1 à 3, dans lequel ledit nanofil est un nanofil à base d'oxyde de titane.

6. Procédé selon l'une quelconque des revendications 1 à 5, dans lequel ladite couche d'oxyde est dopée.

7. Procédé selon l'une quelconque des revendications 1 à 6, dans lequel ladite étape (b) comprend une première étape d'anodisation destinée à former un film poreux sous la forme d'une couche d'oxyde sur ledit substrat métallique et une deuxième étape d'anodisation destinée à former un film poreux sous la forme d'une couche d'oxyde organisée sur ledit substrat métallique.

8. Procédé selon l'une quelconque des revendications 1 à 7, dans lequel ladite étape (d) est mise en œuvre par l'intermédiaire d'un dépôt d'une couche atomique.

9. Procédé selon la revendication 8, dans lequel le dépôt en question est mis en œuvre à une température qui est comprise entre 100 °C et 200 °C.

10. Procédé selon l'une quelconque des revendications 1 à 9, dans lequel ladite étape (e) est mise en œuvre par l'intermédiaire d'une gravure par voie sèche.

11. Procédé selon l'une quelconque des revendications 1 à 9, dans lequel ladite étape (e) est mise en œuvre par l'intermédiaire d'une gravure anisotrope, de manière préférentielle par l'intermédiaire d'une gravure ionique réactive.

12. Procédé selon l'une quelconque des revendications 1 à 11, dans lequel ladite étape (f) est mise en œuvre par l'intermédiaire d'une gravure par voie humide.

13. Procédé selon l'une quelconque des revendications 1 à 12, dans lequel ledit procédé comprend en outre une étape supplémentaire de recuit entre lesdites étapes (c) et (d).

14. Procédé selon l'une quelconque des revendications 1 à 13, dans lequel ledit procédé comprend en outre une étape supplémentaire de traitement avec un plasma d'oxygène après ladite étape (f).

15. Procédé selon l'une quelconque des revendications 1 à 14, dans lequel ledit procédé comprend en outre une étape supplémentaire de recuit après ladite étape (f) ou après ladite étape supplémentaire telle que définie à la revendication 14.
